(19) Europäisches Patentamt
European Patent Office
Office européen des brevets

(11) **EP 0 852 014 B1**

(12) **EUROPEAN PATENT SPECIFICATION**

(45) Date of publication and mention
of the grant of the patent:
**05.03.2003   Bulletin 2003/10**

(51) Int Cl.⁷: **G01R 1/073**

(21) Application number: **96912210.0**

(22) Date of filing: **03.05.1996**

(86) International application number:
**PCT/IT96/00090**

(87) International publication number:
**WO 97/011377 (27.03.1997 Gazette 1997/14)**

(54) **METHOD OF CONTROLLING PRINTED CIRCUITS**

VERFAHREN ZUR KONTROLLE VON LEITERPLATTEN

PROCEDE POUR LE CONTROLE DE CIRCUITS IMPRIMES

(84) Designated Contracting States:
**AT BE CH DE DK ES FI FR GB GR IE LI LU NL PT SE**

(30) Priority: **22.09.1995  IT   UD950181**

(43) Date of publication of application:
**08.07.1998   Bulletin 1998/28**

(73) Proprietor: **New System S.R.L.**
**34170 Gorizia (IT)**

(72) Inventors:
 • **VODOPIVEC, Jozef**
   **I-34170 Gorizia (IT)**

 • **FUMO, Cesare**
   **I-34170 Gorizia (IT)**

(74) Representative: **D'Agostini, Giovanni, Dr.**
**D'AGOSTINI ORGANIZZAZIONE**
**Via G. Giusti 17**
**33100 Udine (IT)**

(56) References cited:
**EP-A- 0 164 722       EP-A- 0 468 153**
**US-A- 4 820 975**

## Description

Technical Field

This invention has as object a method of testing printed circuits.

The invention finds particular even if not exclusive application in the sector of testing printed circuit cards.

Background Art

In prior art machines for the testing printed circuits are known.

These machines generally consist of boards or beds bearing a plurality of electrically conductive needles (in.US-4,820,975 A, providing two opposed needle-boards of electrical conductive needles/probes),between which must be placed the card with the printed circuit to be tested and by activating properly the electric conductivity among the different needles, it is possible to check whether the printed circuit has defects.

Obviously for such control it is necessary for the needles to contact the printed circuit in the proper position.

As the printed circuits are very different, it results necessary to apply over the needle base board, an adaptation board that comprises the same needles but displaced in a different way in conformity with the printed circuit to be controlled. In US-4,820,975 A said adaptation board is substituted by two optical fiber image guides employed to bring the printed circuit card and the respective needle bearing board in alignment. The alignment can be adjusted by means of linear drive mechanisms which allow the position of the needle bearing board to be adjusted in two dimensions relative to the printed circuit card. This solution is based upon the fact that the spring loaded needles are in electric contact with the card to be tested.

The drawback of this solution is the limitation of the machine and the possibility to control only the printed circuits that have at disposal corresponding adapters, e.g. said optical fiber image guides or adaptation boards. Needing as many adaptation boards or optical fiber image guides, as are the cards with different printed circuits to be controlled.

Furthermore it is known that the layers of the circuits are not always coplanar, wherefore a suitable electric conduction for an effective contact is not always ensured, in particular when all said spring load probes are used in electric contact with the card to be tested, malfunctioning is frequent.

EP,A,0 164 722 (Black) 18 December 1985 discloses an automatic test system for testing printed circuit boards (cards) which uses a "bed of nails" in which each nail or needle is fixedly placed in said bed.

In this solution the "bed of nails" has the nail position absolutely fixed and corresponding to the specific pattern of the printed card to be tested.

Drawback of this solution is the requirement of as many "beds of nails" as the different printed circuit cards to be tested.

EP,A,0 164 722 further uses a universal grid matrix having a maximum possibility of positionally fixed needles and a computer program to activate only the required needles at a time. The programming being dependent on the pattern of the printed card to be tested.

This solution has the drawback of continuously reprogramming the machine. Furthermore, because the contact needles are bulky, it is impossible to cover all kinds of patterns.

This problem is avoided rendering displaceable along the coordinate axis said contact needles.

Nevertheless this solution requires a very complicated and expensive construction of the testing machine and in this case the needles cannot be placed closely one next to the other. Furthermore a continuous reprogramming is required to move one needle-board in respect to the other.

Finally, EP,A,0 164 722 discloses a magazine for temporarily storing a plurality of needles and a base receiver member positioned adjacent to the test head (bed or plate) on one side thereof and in a position to contact the base of each needle. The test head (bed or plate) is adapted to receive the needles and position them in a pattern matching test points on the printed circuit board. Means are provided for supporting the test head adjacent to the magazine and in a position to receive needles from the magazine. Means are also provided for transferring selected ones of the needles from the magazine to the test head.

The needles are for this purpose, movable axially from inside the said test head to the outside or vice versa and some of these further axially moved in order to allow contact with the printed circuit of the card to be tested.

This solution is extremely complex because of the mechanisms to move the needles and the program to operate.

Furthermore this solution does not allow a complete universal testing of all kinds of printed circuit cards because of the limitation of the pattern of the test head.

EP,A,0 468 153 (ATG ELECTRONIC) 29 January 1992, discloses a system in which the respective contact needles are not fixed in position on the respective needle bearing hoard, but are movable both axially and from their position along the coordinate axis. Moreover, this document discloses the technical features of subdividing the area to be tested in sectors so that the point to be tested is reachable within the desired area with the corresponding conductive needle, and of simultaneously operating two needles, one opposed to the other, for the test.

In this way it is possible to make the testing machine universal.

Nevertheless, this solution is complex and requires a continuous reprogramming. Furthermore this solution is lengthy because the movable needles are obliged to move for a long way to reach the exact coordinates, and this has to be done continuously during the testing of each single card for the respective interested points to be tested in the circuit.

EP-A-0 547 251 discloses a method for testing a micro circuit, where a "wafer holder" and a "test head ... incorporating a matrix of probes" are provided and wherein said wafer holder is movable on its (X-Y) plane whereas the test head is movable along the orthogonal (Z) direction.

Disclosure of Invention

The purpose of the present invention is that to obviate the above-mentioned drawbacks, and in particular to provide a test method using a universal machine which is able to control the printed and which has a system of conductive detection needles that can be adapted to any type of circuit.

This is obtained by the method as claimed. The machine used for the testing printed circuit cards is of the type comprising needle bearing boards with a plurality of axially movable conductive needles that are connected on their reverse side to analysis means wherein:

- two of said needle bearing boards are used, one opposed to the other and between them is placed for testing said printed circuit card, and,
- one needle bearing board is made movable in respect to the opposed needle bearing board, on the respective plane;

and wherein said axially movable conductive needles are fixedly placed in said needle board bearing boards;

- in said machine, the axial movement of the needles is obtained by electromagnetic means.
- said machine is made in such a way to operate in the testing between two points of said printed circuit card, acting on the upper-side with one needle of the upper needle board bearing means and on the under-side with one needle of the opposite needle board bearing means, after having carried out a respective centring movement of said boards to reach the opposed testing points of said printed circuit card.

In this way it is obtained the immediate advantage of simplifying all the system by making universal the application of the machine on different printed circuits without needing adapters. In fact by this it is possible to activate a board needle in any leading end circuit position and to activate an opposite needle of the opposite board, which thanks to the movability of the same board will be able to reach any definite circuit end point to be tested independently from its position, place and shape.

In this way the universalization of the testing system for any card is ensured since among a plurality of needles it is possible to make interact only some of them, centring more easily the desired positions of the printed circuit.

Further advantage derives from the fact that with the axial movability of the needles it is possible to contact better the respective desired points of the circuit even when the card or the layer of the circuit is not perfectly on the same plane in all its points.

Since the needles are made axially movable by electromagnetic means, the desired needle is operated in a simple and safe way.

These and other advantages will be shown by the following description of an embodiment employing preferred solutions with the help of the included drawings whose details are not to be considered limitative but only given as an example.

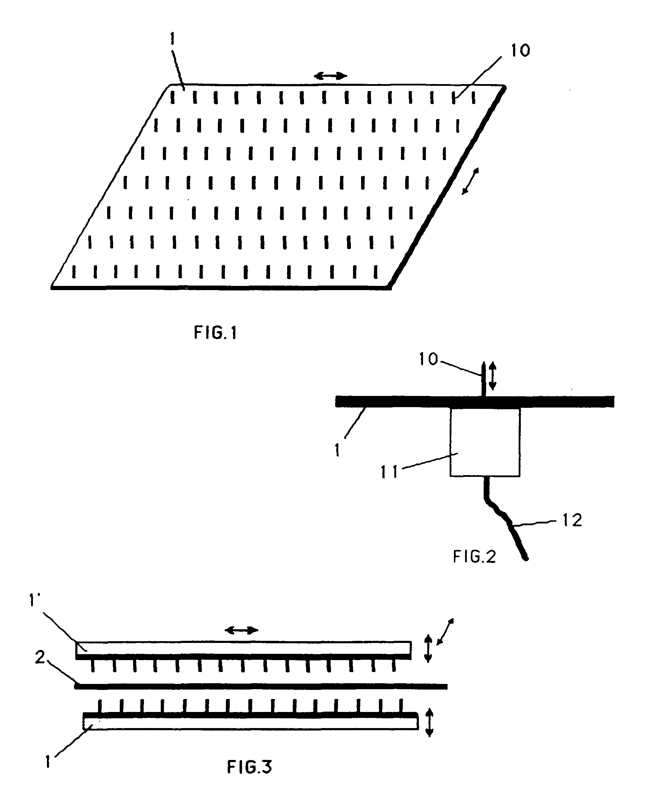

Figure 1 is a perspective schematic view of a detection board (bed);

Figure 2 is a cross-sectional schematic view of an axially movable detection needle.

Figure 3 is a cross-sectional view of the preferred embodiment with two opposite detection boards movable one with respect to the other and with the card to be controlled placed between them.

In particular in the figures the two detection testing boards are indicated with 1 and 1'.

Each board has a plurality of needles 10 axially movable by electromagnet 11.

Each needle is electrically connected 12 to a known art electric parameter control system.

The opposite boards as mentioned are movable one with respect to the other for the operative positioning.

The card positioned between these is indicated with 2.

The system provides a control by a net list "netlist" with relative positions of single points.

The connection test is carried out from point to point, so that for testing the connections of a net made of n points, n-1 tests are necessary between pairs of points selected in such a way to cover all the connections.

The test on short circuits among different nets, is made by selecting a point out of each pair of nets.

The maximum number for testing n nets in this way, is calculated with the following formula:

$$n*(n-1)/2.$$

This number can be reduced by selecting only alongside nets, that is the ones close to each other in a pre-determined distance.

The positions to be tested are subdivided in sectors corresponding to the number of needles in the movable board (bed), so that the point to be tested is reachable with the position and with one of the testing needles.

After the points to be tested are reached, it is necessary to check the connection or insulation.

To shorten the time used for the movements, it is possible to optimize the paths of the axes, by modifying the frequency of the single tests.

The machine is made up of a frame on which are fixed two opposite boards and independently, movable with respect to the two orthogonal axes.

On the boards are fixed the testing needles directly operated by electromagnet in their axial movement.

At the beginning, the printed circuit is placed on a bearing frame that transports it between the two boards.

In this position the card remains fixed.

The boards are put close to the card and the test begins.

Each board is independently controlled and operated, so that the maximum stroke necessary is defined by the distance among the needles.

In correct position, the electromagnet operates the needle on the surface to be contacted and thus by a pair of needles simultaneously operated the functionality of the circuit between the two desired points is controlled, namely the respective continuity and eventual short circuits.

The process proceeds by points in repetitive way as desired.

Advantageously also the card bearing may be moved with respect to one or the other board.

In this way is obtained a wider universalization of use.

**Claims**

1. A method for testing printed circuit cards (2), said method using a test machine of the type comprising two needle bearing boards (1, 1') each with a plurality of axially movable conductive needles (10) that are connected on their reverse side (12) to analysis means for the electric parameters between two conductive needles (10) building up a pair of needles, wherein :

  - the two needle bearing boards (1, 1') are used one opposed to the other and between them is to be placed for testing the printed circuit card (2) and
  - one needle bearing board (1) is made movable in respect to the opposed needle bearing board (1') on the respective plane,
  - in order to operate the testing between two points of said printed circuit card (2), the test machine system provides a control by a net list with relative positions of single points,

  - the connection test is carried out from point to point, so that for testing the connections of a net made of n points n-1 tests are necessary between pairs of points selected in such a way to cover all the connections,
  - the testing for short circuits between different nets is made by selecting a point out of each pair of nets,
  - the maximum number for testing n nets is calculated by the following formula :

$$n_{max} = n*(n-1)/2,$$

said maximum number is reduced by selecting only adjacent nets, that is the ones close to each other in a pre-determined distance,

and wherein

  - each needle bearing board (1, 1') in which said axially movable conductive needles (10) are fixedly placed is independently controlled and operated so that the maximum stroke necessary is defined by the distance between one of said two conductive needles (10) and the closest conductive needle (10) of the same needle bearing board (1, 1'),
  - the positions to be tested are subdivided in sectors corresponding to the number of conductive needles (10) of the corresponding needle bearing board (1, 1') so that the point to be tested is reachable within the desired position with the corresponding conductive needle (10),
  - said pair of needles (10) is simultaneously operated one opposed to the other for the test,
  - the test proceeds by points in repetitive way.

**Patentansprüche**

1. Eine Methode zum Testen von Flachbaugruppen (2) mit einer Testmaschine mit zwei Nadelbrettern (1, 1'), jedes mit einer Anzahl von axial beweglichen leitenden Nadeln (10), die auf ihrer Rückseite (12) mit Mitteln zur Analyse der elektrischen Parameter zwischen zwei leitenden Nadeln (10), die ein Nadelpaar bilden, ausgestattet sind, wobei:

  - die beiden Nadelbretter (1, 1') einander gegenüberliegen und zwischen ihnen zwecks Tests die Flachbaugruppe (2) zu plazieren ist, und
  - ein Nadelbrett (1) beweglich in bezug auf das gegenüberliegende Nadelbrett (1') in der betreffenden Ebene ist,

- zum Testen zwischen zwei Punkten von besagter Flachbaugruppe (2) weist das Testmaschinensystem eine Steuerung durch eine Netzliste mit relativen Positionen von einzelnen Punkten auf,
- der Anschlusstest wird von Punkt zu Punkt durchgeführt, so dass zum Testen der Anschlüsse eines Netzes aus n Punkten n-1 Tests zwischen Paaren von Punkten notwendig sind, die so ausgewählt werden, dass alle Anschlüsse abgedeckt werden,
- die Kurzschlusstests zwischen verschiedenen Netzen erfolgen durch Auswahl eines Punktes aus jedem Netzpaar,
- die Höchstzahl zum Testen von n Netzen wird nach der folgenden Formel berechnet:

$$n\ max = n*(n-1)/2,$$

besagte Höchstzahl verringert sich beim Auswählen nur angrenzender Netze, also nahe einander in einem vorbestimmten Abstand,

und wobei

- jedes Nadelbrett (1, 1'), in dem besagte axial bewegliche leitende Nadeln (10) fest plaziert sind, unabhängig kontrolliert und betrieben wird, so dass der notwendige Höchsthub definiert ist durch den Abstand zwischen einer der besagten beiden leitenden Nadeln (10) und der nächsten leitenden Nadel (10) desselben Nadelbretts (1, 1'),
- die zu testenden Positionen in Abschnitte entsprechend der Zahl der leitenden Nadeln (10) des entsprechenden Nadelbretts (1, 1') unterteilt sind, so dass der zu testende Punkt innerhalb der gewünschten Position mit der entsprechenden leitenden Nadel (10) erreichbar ist,
- besagtes Nadelpaar (10) gleichzeitig, das eine dem anderen gegenüberliegend, für den Test betrieben wird,
- der Test Punkt für Punkt stets auf dieselbe Weise abläuft.

## Revendications

1. Une méthode pour tester des cartes à circuits imprimés (2), qui utilise une machine à tests du type comprenant deux plaques d'aiguilles (1, 1) chacune avec une pluralité d'aiguilles conductrices mobiles axialement (10) qui sont liées sur leur côté antérieur (12) à des moyens d'analyse pour les paramètres électriques entre deux aiguilles conductrices (10) qui forment une paire d'aiguilles, dans laquelle :

- les deux plaques d'aiguilles (1, 1) sont utilisées l'une opposée à l'autre et la carte à circuits imprimés (2) doit être placée entre elles pour effectuer les tests et
- une plaque d'aiguilles (1) est mobile par rapport à la plaque d'aiguilles opposée (1) dans le plan respectif,
- pour effectuer le test entre deux points de ladite carte à circuits imprimés (2), le système de machine à tests pourvoit un contrôle par une liste de réseau avec les positions relatives de points individuels,
- le test de connexion est réalisé en passant d'un point à l'autre, de manière que pour tester les connexions d'un réseau composé de n points, n-1 tests sont nécessaires entre des paires de points sélectionnés de façon à couvrir toutes les connexions,
- les tests pour des courts circuits entre les différents réseaux est fait e n sélectionnant un point de chaque paire de réseaux,
- le nombre maximal pour tester n réseaux est calculé avec la formule suivante:

$$n\ max = n*(n-1)/2,$$

ledit nombre maximal est réduit si on sélectionne seulement des réseaux adjacents, c'est-à-dire l'un près l'autre à une distance prédéterminée,

et dans laquelle

- chaque plaque d'aiguilles (1, 1) dans lequel lesdites aiguilles conductrices mobiles axialement (10) sont fixément placées, est controlée et opérée de façon indépendante, de manière que la course maximale nécessaire est définie par la distance entre une des deux aiguilles conductrices (10) et l'aiguille conductrice (10) plus proche de la même plaque d'aiguilles (1, 1),
- les positions à tester sont subdivisées en secteurs correspondant au nombre d'aiguilles conductrices (10) de la plaque d'aiguilles correspondante (1, 1) de manière que le point à tester peut être rejoint dans la position désirée avec l'aiguille conductrice correspondante (10),
- ladite paire d'aiguilles (10) est opérée simultanément l'une opposée à l'autre pour le test,
- le test procède point après point de façon répétitive.

FIG.1

FIG.2

FIG.3